Europäisches Patentamt

European Patent Office

Office européen des brevets

(11) Publication number : **0 618 576 A2**

(12) **EUROPEAN PATENT APPLICATION**

(21) Application number : 94302362.2

(22) Date of filing : 31.03.94

(51) Int. Cl.$^5$ : **G11B 20/14, H03M 7/42**

(30) Priority : 02.04.93 JP 76692/93
18.03.94 JP 48429/94

(43) Date of publication of application :
05.10.94 Bulletin 94/40

(84) Designated Contracting States :
AT BE CH DE DK ES FR GB GR IE IT LI LU MC
NL PT SE

(71) Applicant : **KABUSHIKI KAISHA TOSHIBA**
**72, Horikawa-cho**
**Saiwai-ku**
**Kawasaki-shi Kanagawa-ken 210 (JP)**

(72) Inventor : **Hirayama, Koichi, c/o Intellectual**
**Property Div.**
**Toshiba Corporation,**
**1-1-1, Shibaura**
**Minato-ku, Tokyo (JP)**
Inventor : **Ishizawa, Yoshiyuki, c/o Intellectual**
**Property Div**
**Toshiba Corporation,**
**1-1-1, Shibaura**
**Minato-ku, Tokyo (JP)**

(74) Representative : **Muir, Ian R. et al**
**HASELTINE LAKE & CO.**
**Hazlitt House**
**28 Southampton Buildings**
**Chancery Lane**
**London WC2A 1AT (GB)**

(54) **Digital data modulation/demodulation system.**

(57)    A digital data modulation system having, a
separator for separating a consecutive binary
data sequence to four-bit code-words, a four-
to-nine ([4.9]) converter for converting the
four-bit code-words into nine-bit modulated
code-words and a code selector for selecting a
code among nine-bit code-words containing
minimum three bits of "0" between a preceed-
ing bit of "1" and its following bit of "1" so that
there should not be less than two consecutive
bits of "0" between a selecting code and a
modulated code-word which is to be converted
later by the [4.9] converter.

FIG. 5

EP 0 618 576 A2

The present invention generally relates to a digital data modulation/demodulation system, and more particularly to a modulator/demodulator which is used for digital data recording/reproducing to/from optical discs etc., or communication transmission.

As, there are an EFM (Eight-to-Fourteen Modulation) system using fixed length words used for an audio-soft or audio signal storing CD (Compact Disc) as disclosed in the Japanese Patent Disclosure (Tokkai-Sho) 57-48848 (now granted as Tokko-Hei 05-19332) and a Run-Length Limited two-to-seven (hereinafter referred to as RLL [2,7]) modulation system adopted for writable optical disc, as disclosed in the Japanese Patent Disclosure (Tokkai-Sho) 50-142131 (or corresponding USP 3.689.899).

However, there was such a problem that in order to achieve more high-density recording in the conventional EFM modulation system and a two-to-seven (hereinafter referred to as [2,7]) modulation system, a short-wave laser had to be developed while it couldn't be able to fully cope with the realization of large capacity storage media for image data etc., which are currently under development.

In the modulation systems described above, regarding modulated codes after conversion, such characteristic parameters as a bit interval T, a minimum inversion interval Tmin, a maximum inversion interval Tmax, a detection window width Tw, a digital sum value DSV, etc., have been established. In particular, when it is intended to achieve the high-density recording, it is necessary to make the minimum inversion interval Tmin and the detection window width Tw large while keeping the maximum inversion interval Tmax as small as possible. The minimum inversion interval Tmin is the most important parameter as it directly affects the shortest bit length that can be reconstructed on an optical disc.

Here, a shortest writable or readable bit length on a disc is determined by an attribute of the light source, i.e., a wavelength of a laser beam generated from an optical head for writing or reading optical data on a disc, as well as a numerical aperture NA of an optical objective lens to minimize a light spot diameter as small as possible, etc. Therefore, in order to make the bit length more short and increase a recording density, it is needed to develop a laser with short wavelength beam and expand the numerical aperture NA, but it was difficult to limit a writable disc bit length to below a fixed value as it was difficult to use them in practical use.

Thus, in order to make much more data to be recorded in the present writable and readable bit lengths, a development of a modulation system having more larger minimum inversion interval Tmin by the current laser technology is expected. Further, when the minimum inversion interval Tmin is made large, it sacrifices or deteriorates other characteristic parameters and the maximum inversion interval Tmax, detection window width Tw, etc. may be deteriorated. However, they can be suppressed through a signal processing when data are reconstructed. Therefore, in order to achieve a high density recording in a system utilizing the current optical system, it is indispensable to develop a modulation system having a sufficient length of the minimum inversion interval Tmin

As described above, conventional digital data modulation systems, such as the EFM modulation system and the [2,7] modulation system have such a defect that as a priority of their performances was placed on an easy process of data reconstruction or demodulation, a size of minimum inversion interval Tmin was insufficient for realizing a large capacity optical disc intended for image data storage.

It is, therefore, an object of the present invention to provide digital data modulation/demodulation system which is able to realize a large capacity optical disc by removing the defects as described above for achieving higher density recording of data using currently available optical systems.

In order to achieve the above object, a digital data modulation/demodulation system according to one aspect of the present invention includes a separator for separating a consecutive binary data sequence into every four-bit code-words, a four-to-nine (hereinafter referred to as [4,9]) converter using variable length words for converting the separated four-bit code-words into nine-bit modulated code-words having three consecutive bits of "0" and a code selecting means for selecting a modulated code-word among nine-bit code-words having minimum three bits of "0" between a first bit of "1" and a following second bit of "1", so that there should not be less than two consecutive bits of "0" between a preceding and succeeding modulated code-words.

In the modulator/demodulator having the arrangement as described above, when separating a consecutive binary data sequence into four-bit code-words and converting these separated four-bit code-words into nine-bit modulated code-words, bits are so controlled by a code selecting means that less than two consecutive bits of "0" are not generated between a current modulated code-word and a modulated code-word to be converted next.

For a better understandings of the present invention and many of the attendant advantages thereof, reference will now be made by way of example to the accompanying drawings, wherein:

FIGURES 1 through 4 are explanatory diagrams of code conversion tables showing an embodiment of the present invention;

FIGURE 5 is a circuit block diagram of an encoder of the present invention based on the conversion tables in FIGURES 1 through 4;

2

FIGURE 6 is a circuit diagram showing the definite construction of a three-input OR gate block of the encoder shown in FIGURE 5;

FIGURES 7 through 11 are truth tables for conversion logic circuits TLGC(a) through TLGC(e) of the encoder shown in FIGURE 5;

FIGURE 12 is a circuit block diagram of the decoder of the present invention based on the conversion tables shown in FIGURES 1 through 4;

FIGURES 13 through 15 are truth tables of conversion logic circuits TLGC(f) through TLGC(h) of the decoder shown in FIGURE 12;

FIGURES 16 through 18 are diagrams showing a specific code inserting method and code tables showing specific code examples used for DSV control in the present invention; and

FIGURE 19 and 20 are graphs of test results showing the characteristics (the effects) of the present invention by comparing with a conventional EFM modulation system.

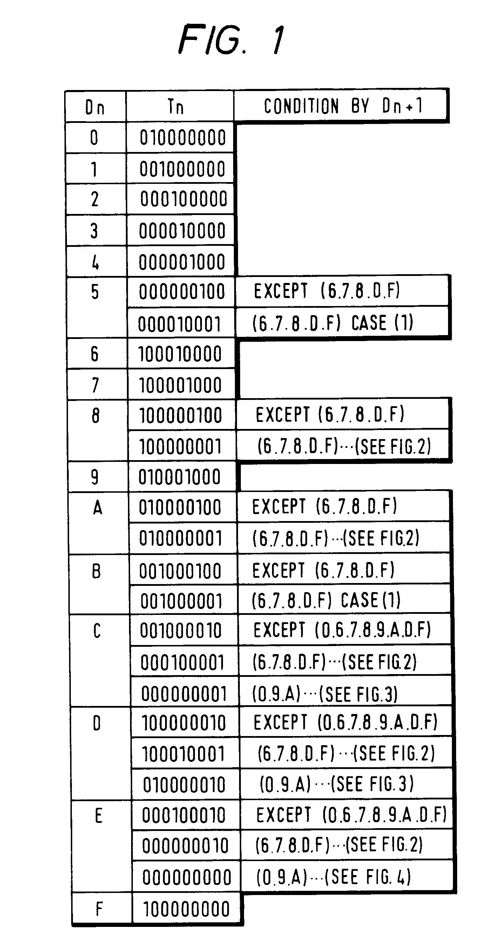

The present invention will be described in detail with reference to the FIGURES 1 through 20.

FIGURE 1 is an explanatory diagram of a code conversion table showing an embodiment of the present invention. Dn shows an input binary data sequence separated in four bit code-words and expressed in the hexadecimal notation. Tn shows a binary bit pattern after converting the input Dn into nine-bit data. Only Tn having minimum three bits of "0" between a preceding bit "1" and a succeeding bit "1" has been selected.

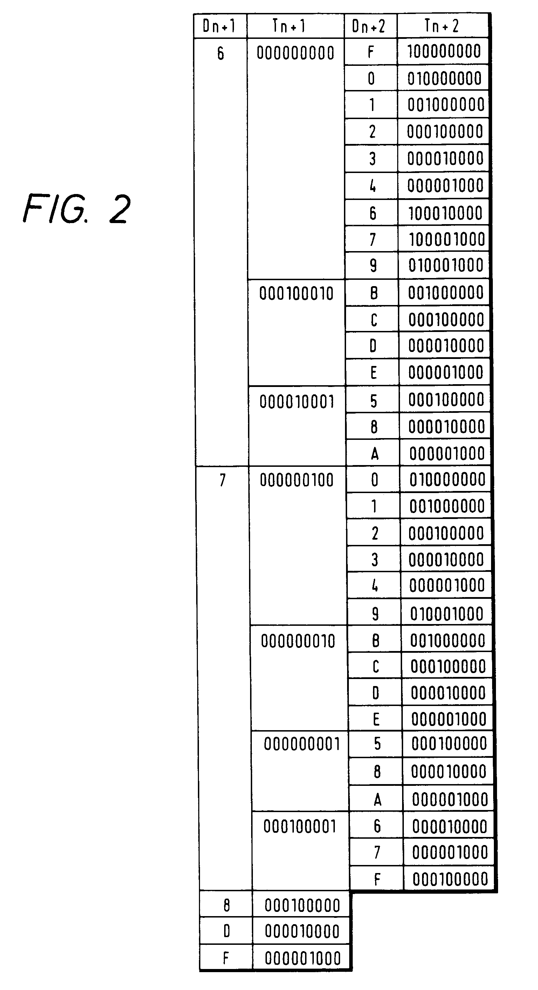

For some Dn, there are provided two to three kinds of Tn pattern for a balance with a succeeding data (Dn+1) and Tn pattern is specified according to a value of Dn+1. For instance, in case of Dn = 5, two kinds of Tn: "000000100" and "000010001" are provided, when Dn+1 is 6, 7, 8, D, or F, data is converted into "000010001" andin other cases, itis converted into "000000100". If "000010001" is selected as Tn, data is converted according to a conversion table shown in FIGURE 2 for Dn+1 and further, including a Dn+2 succeeding to it in some cases.

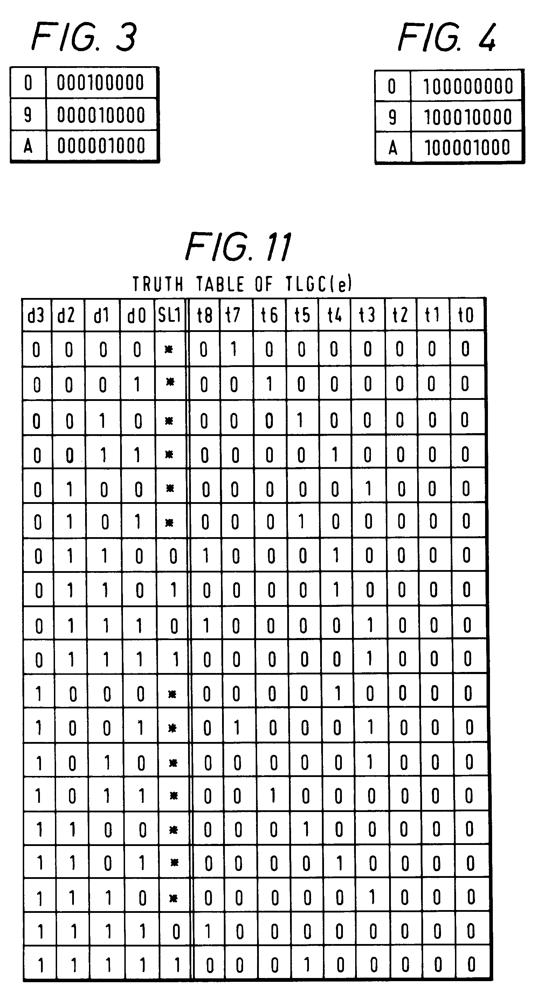

When explaining by taking a specified example, in case of D = 5, Dn+1 = 6, Dn+2 = 7, they are converted as Tn = "000010001", Tn+1 = "000000000" and Tn+2 = "100000000". Further, in case of Dn = C, three kinds of Tn: "001000010", "000100001" and "000000001" are provided as shown in FIGURE 1. In case of Dn+1 = 6, 7, 8, D or F, it is converted into "000100001", in case of Dn+1 = 9 or A, it is converted into "000000001" and in all other cases, data is converted into "001000010". For instance, in case of Dn = C, Dn+1 = 0, they are converted into Tn = "000000001" and Tn+1 = "000100000" according to a table shown in FIGURE 3.

Likewise, in case of Dn = D or E, three kinds of Tn+1 shown in FIGURE 1 are provided. Further, in case of Dn = E and Dn+1 = 0, 9 or A, Tn+1 is specified according to a table shown in FIGURE 4. This is because the number of bits "0" can be reduced when compared with a case using the table shown in FIGURE 3 and if maximum inversion interval Tmax is not a problem, there will be no problem even when the conversion is made according to the table shown in FIGURE 3.

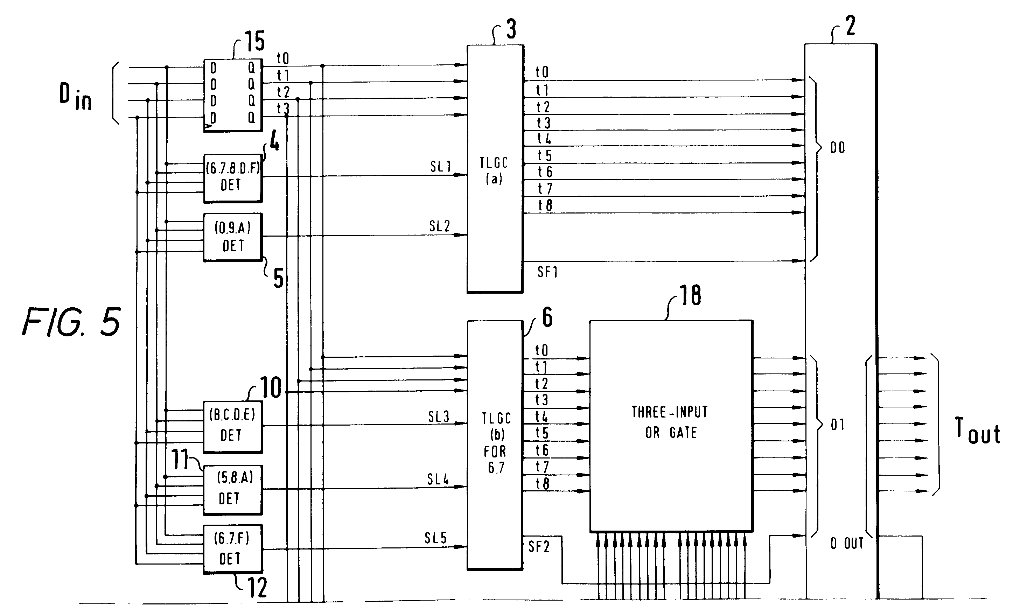

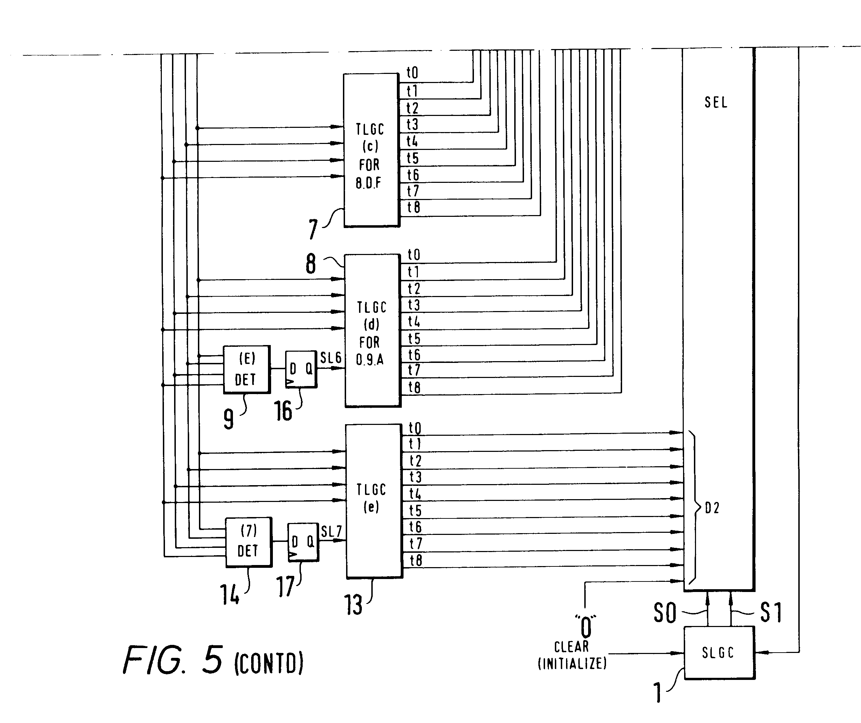

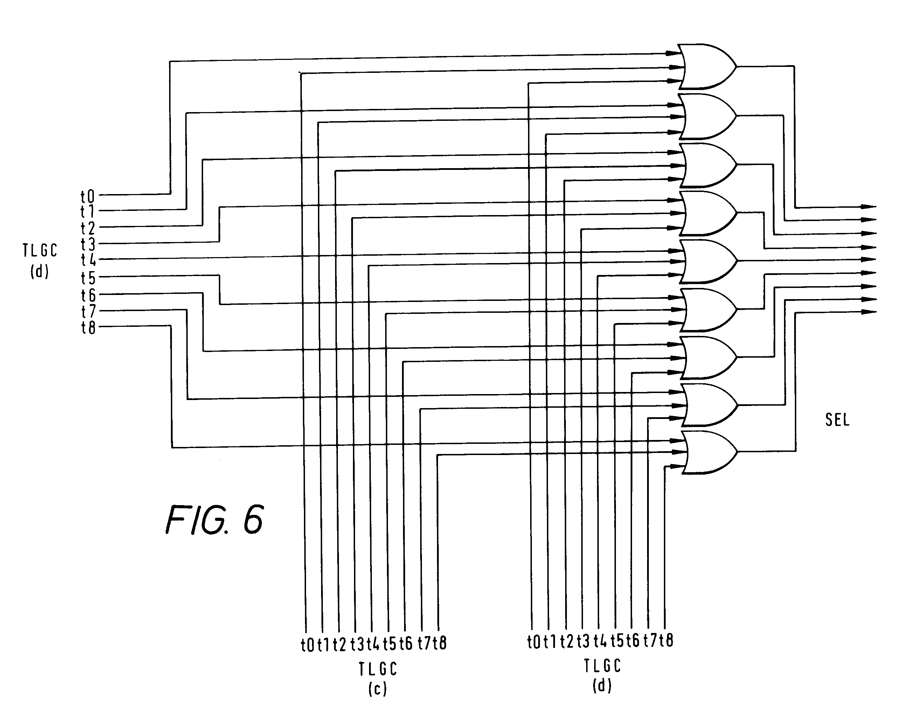

FIGURE 5 is a circuit block diagram of an encoder to realize the conversion tables shown in FIGURES 1 through 4. In the initial state, outputs S0, S1 of a selector controller 1 show "0" and a selector (SEL) 2 selects DO input, accordingly. The output of a first conversion logic circuit, that is, the output of the TLGC(a) 3 is input directly to the selector 2. The output of a second conversion logic circuit in the same construction as the first conversion logic circuit, that is, the TLGC(b) is input to the selector 2 via a three-input OR gate 18. The specified construction of the three-input OR gate block 18 is shown in FIGURE 6.

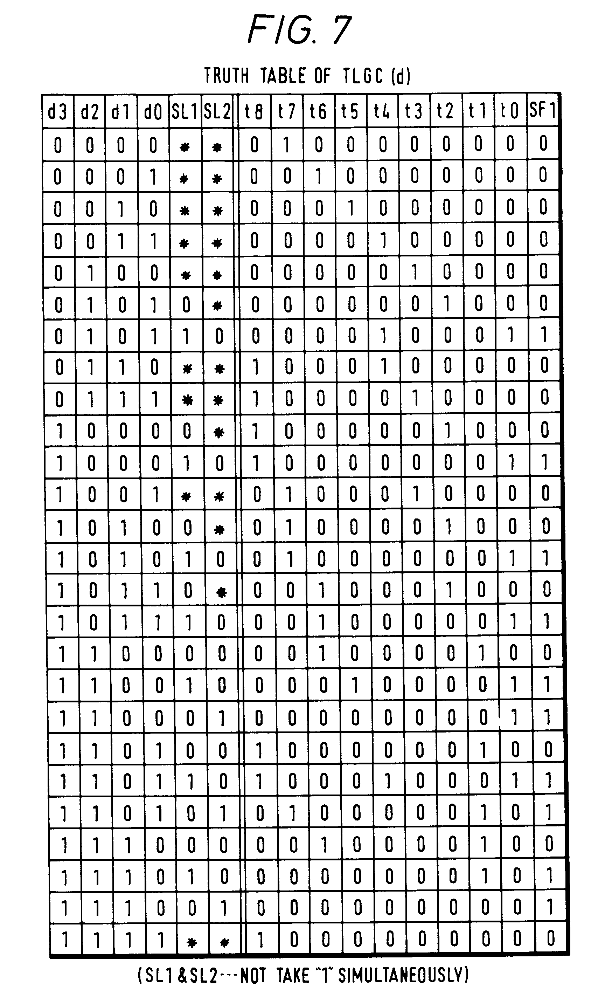

A truth table of the TLGC(a) 3 is shown in FIGURE 7. Whether a value of four-bit code-word (Dn+1) to be input next is 6, 7, 8, D, F or 0, 9, A is judged from the output SL1 of DET 4 and the output SL2 of DET 5.

If the output SF1 of the TLGC(a) 3 shows "1", the outputs of the selector controller 1 are updated to SO = "1", S1 = "0" and the selector (SEL) 2 selects the D1 side, accordingly. In case of SF1 = "0", the outputs are not updated and the selector (SEL) 2 is kept in the DO selected state and the conversion of next code-word Dn+1 is made by the TLGC(a) 3.

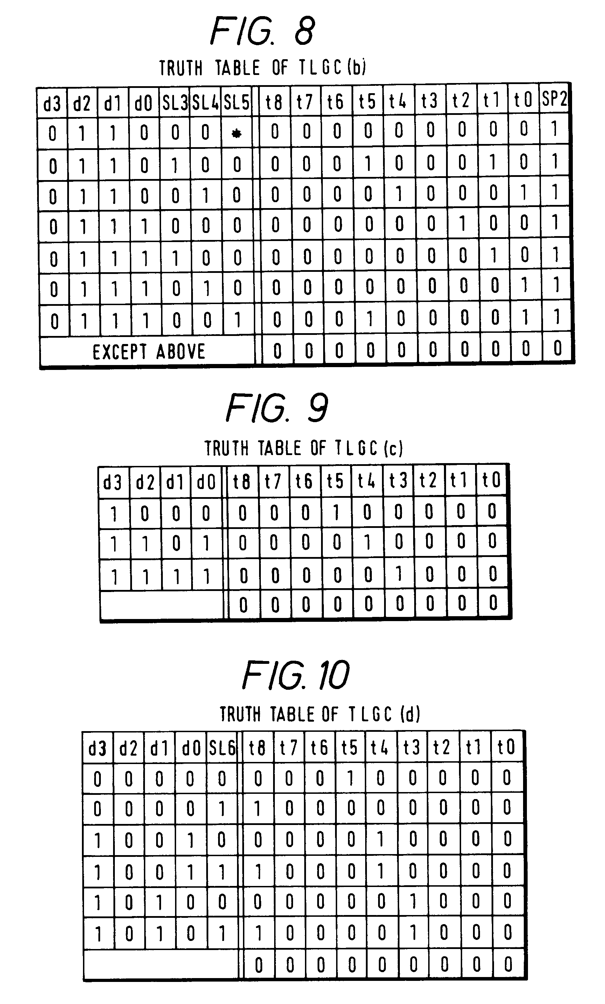

If the selector (SEL) 2 selects the D1 side, the next code-word Dn+1 is converted by one of the conversion logic circuits TLGC(b) 6 for (6, 7), TLGC(c) 7 for (8, D, F) or TLGC(d) 8 for (0, 9, A). The outputs of the TLGC(b) 6, TLGC(c) 7 and TLGC(d) 8 are input to the three-input OR gate 18, respectively and select prescribed conversion outputs. Truth tables of the TLGC(b) 6, TLGC(c) 7 and TLGC(d) 8 are shown in FIGURES 8, 9 and 10, respectively.

In case of the code-word Dn+1 = 8, D, F, data is converted to the corresponding Tn+1 by the TLGC(c) 7. In case of Dn+1 = 0, 9 or A, data is converted to the corresponding Tn+1 by the TLGC(d) 8. In this case, whether the first code-word Dn is B or other than E is judged by (E) DET 9 and corresponding to the result of judgment, the conversion is made according to the table shown in FIGURE 2 or the table shown in FIGURE 3.

On the other hand, in case of the code-word Dn+1 = 6 or 7, Tn, Tn+1 and Tn+2 are decided by the second conversion logic circuit TLGC(b) 6 based on the outputs SL3, SL4 and SL5 of the DET 10 for (B, C, D, E), the DET 11 for (5, 8, A) and the DET 12 for (6, 7, F) for judging its value including a value of the succeeding Dn+2 in addition to the output of a data latch 15.

In case of the code-word Dn+1 is other than 6 and 7, the output SF2 of the TLGC(b) 6 is "0" and the outputs of the selector controller 1 SLGC1 is restored to the initial state S0 = "0" and S1 = "0", correspondingly and the selector (SEL) 2 selects D0.

In case of the code-word Dn+1 = 6 or 7, the output SF2 becomes "1" and the outputs of the selector controller SLGC1 is updated to S0 = "0" and S1 = "1", correspondingly, and the selector (SEL) 2 selects D2.

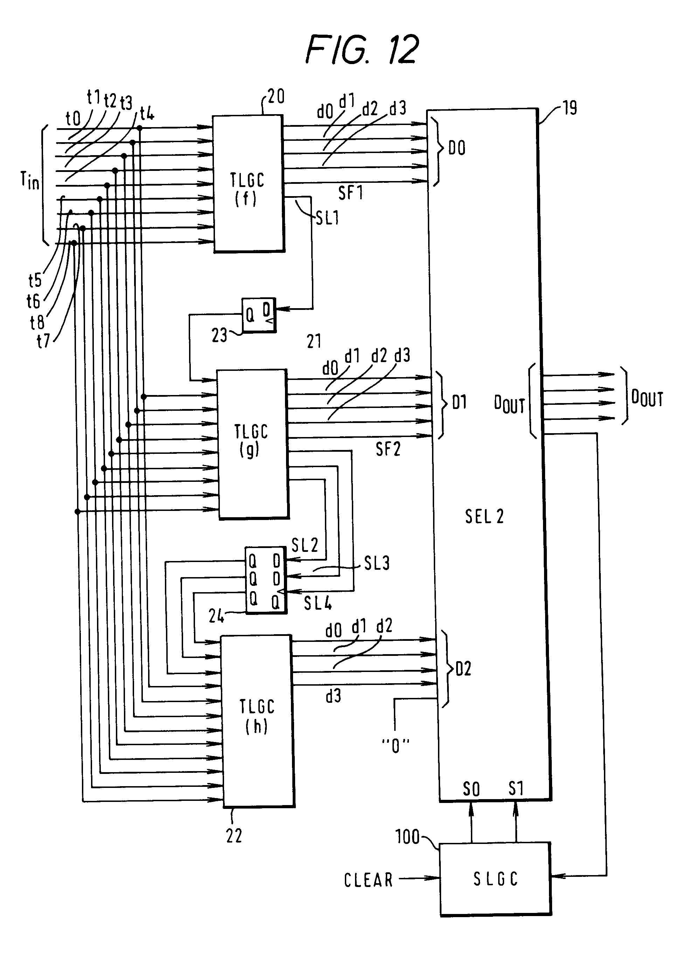

A succeeding code-word Dn+2 is converted by the TLGC(e) 13. In this case, whether a preceding code-word Dn+1 is 7 or 6 is detected by (7) DET 14 and the corresponding conversion to the data Tn+2 is made according to the table shown in FIGURE 2. After the conversion by selecting D2, the outputs of the selector controller 1 are restored to S0 = "0", S1 = "0" and the selector (SEL) 2 selects D0. A truth table of the TLGC(e) 13 is shown in FIGURE 11.

Thus, although there is a restriction of maximum three code-words, it is so controlled that the number of bits "0" between two bits of "1" is maintained in three or more in the converted code-words.

FIGURE 12 shows a circuit block diagram of a decoder to realize the conversion tables shown in FIGURES 1 through 4. A selector controller 100 operates in the entirely same manner as the selector control circuit 1 of the encoder. That is, both the outputs S0 and S1 of the selector control circuit 100 under the initial state show "0" and the selector (SEL2) 19 selects the D0 input, correspondingly.

The first process of encoded data Tn is carried out by a conversion logic circuit TLGC(f) 20 and restoration handling data Dn including the output SF1 showing whether the data Tn+1 successively input is restricted and the output SL1 showing that the data Tn+1 is one of 0, 6, 7, 8, 9, A, D and F is output.

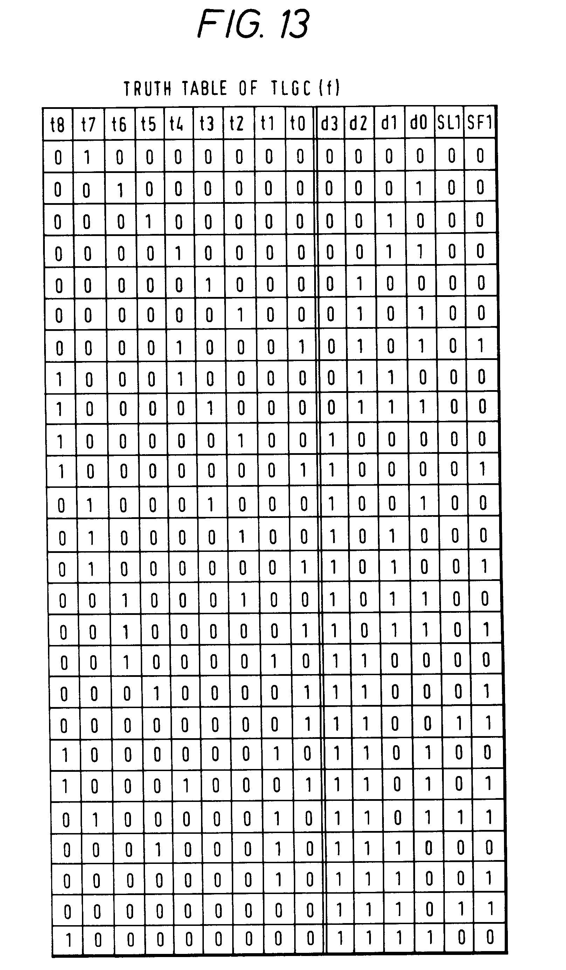

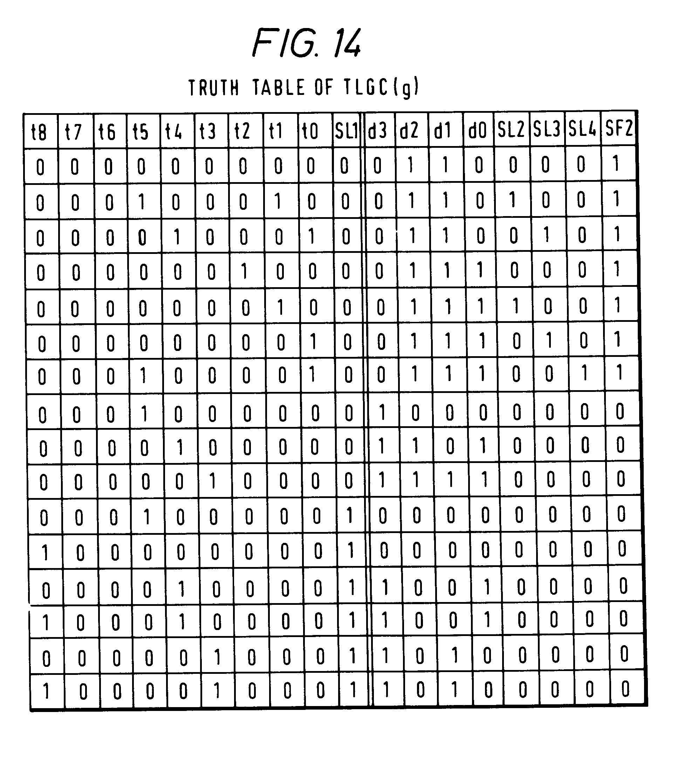

FIGURE 13 shows the truth table of the TLGC(f) 20. If the output SL1 is "0", the outputs S0 and S1 of the selector control circuit 100 are kept in the initial state and the selector (SEL2) 19 selects D0 input, correspondingly. As a result, the data Tn+1 is processed in the same manner as in Tn data. In case of SL1 = "1", the outputs of the selector control circuit 100 are updated to S0 = "1" and S1 = "0" and the selector (SEL2) 19 selects D1, correspondingly. In this case, the data Tn+1 is processed by the TLGC(g) 21. The truth table of the TLGC(g) 21 is shown in FIGURE 14.

This TLGC(g) 21 further outputs a restoration handling data Dn including an output SF2 showing whether the data Tn+2 successively input is restricted, an output SL2 showing that the data is one of B, C, D, and E, an output SL3 showing that the data is one of 5, 8 and A, and an output SL4 showing that the data is one of 6, 7 and F.

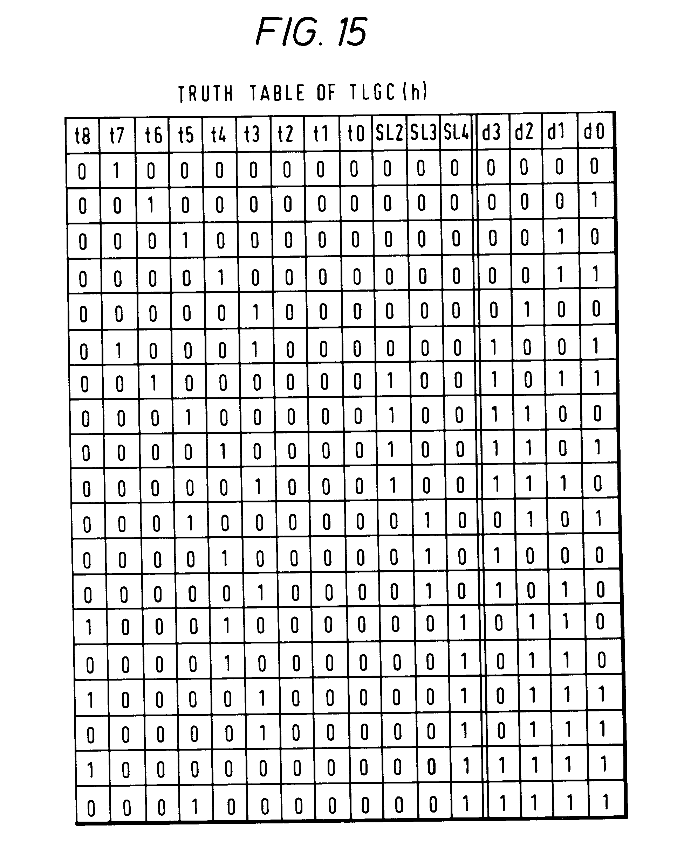

In case of the output SL2 = "0", both the outputs S0 and S1 of the selector control circuit 100 are restored to the initial state "0" and the selector (SEL2) 19 selects D0 input, correspondingly. In case of the output SL2 = "1", the outputs of the selector control circuit 100 are updated to S0 = "0" and S1 = "1" and the selector (SEL2) 19 selects D2. In this case, the data Tn+2 is converted by the TLGC(h) 22 according to information SL2, SL3 and SL4 at the preceding restoration of code-word Dn+1. The truth table of the TLGC(h) 22 is shown in FIGURE 15. After the conversion of data Tn+2, the outputs of the selector control circuit 100 are restored to the initial state of S0 = "0" and S1 = "0" and the selector (SEL2) selects D0, correspondingly.

As described above, the decoder processes the restoration while judging whether the decoding of a received code-word is completed. In this case, although it is necessary to make a judgment as to which code-word is in the initial state, SYNC code, etc. are generally inserted at a fixed interval as a measure when any error is generated and therefore, there is no problem.

Next, a correspondence table of input code sequence vs conversion code series showing actual code conversion according to the conversion rule described above is shown.

Input Code Sequence     Conversion Output Code Sequence

[ Dn ]            [ Tn ]

| HEX-Code | Bit-Pattern | Bit-Pattern |
|----------|-------------|-------------|
| o | 0000 | 010000000 |
| 1 | 0001 | 001000000 |
| 2 | 0010 | 000100000 |
| 3 | 0011 | 000010000 |
| 4 | 0100 | 000001000 |
| 6 | 0110 | 100010000 |
| 7 | 0111 | 100001000 |
| 9 | 1001 | 010001000 |
| F | 1111 | 100000000 |
| 5 | 0101 | 000000100 |

[ Dn-Dn+1 ]          [ Tn-Tn+1 ]

| HEX-Code | Bit-Pattern | Bit-Pattern |
|----------|-------------|-------------|
| 5-8 | 0101-1000 | 000010001-000100000 |
| 5-D | 0101-1101 | 000010001-000010000 |
| 5-F | 0101-1111 | 000010001-000001000 |
| 5-6 | 0101-0110 | 000010001-000000000 |

[ Dn-Dn+1-Dn+2 ]     [ Tn-TN+1-Tn+1 ]

| 5-6-5 | 0101-0110-0101 | 000010001-000010001-000100000 |
|-------|----------------|-------------------------------|
| 5-6-8 | 0101-0110-1000 | 000010000-000010001-000010000 |
| 5-6-A | 0101-0110-1010 | 000010001-000010001-000001000 |
| 5-6-B | 0101-0110-1011 | 000010001-000100010-001000000 |

| | | |
|---|---|---|
| 5-6-C | 0101-0110-1100 | 000010001-000100010-000100000 |
| 5-6-D | 0101-0110-1101 | 000010001-000100010-000010000 |
| 5-6-E | 0101-0110-1110 | 000010001-000100010-000001000 |
| | | |
| 5-7 | 0101-0111 | 000010001-000000100 |
| 5-7-5 | 0101-0111-0101 | 000010001-000000001-000100000 |
| 5-7-6 | 0101-0111-0110 | 000010001-000100001-000010000 |
| 5-7-7 | 0101-0111-0111 | 000010001-000100001-000001000 |
| 5-7-8 | 0101-0111-1000 | 000010001-000000001-000010000 |
| 5-7-A | 0101-0111-1010 | 000010001-000000001-000001000 |
| 5-7-B | 0101-0111-1011 | 000010001-000000010-001000000 |
| 5-7-C | 0101-0111-1100 | 000010001-000000010-000100000 |
| 5-7-D | 0101-0111-1101 | 000010001-000000010-000010000 |
| 5-7-E | 0101-0111-1110 | 000010001-000000010-000001000 |
| 5-7-F | 0101-0111-1111 | 000010001-000100001-000100000 |
| | | |
| 8 | 1000 | 100000100 |
| | | |
| 8-8 | 1000-1000 | 100000001-000100000 |
| 8-D | 1000-1101 | 100000001-000010000 |
| 8-F | 1000-1111 | 100000001-000001000 |
| | | |
| 8-6 | 1000-0110 | 100000001-000000000 |
| [ Dn-Dn+1-Dn+2 ] | | [ Tn-TN+1-Tn+1 ] |
| 8-6-5 | 1000-0110-0101 | 100000001-000010001-000100000 |
| 8-6-8 | 1000-0110-1000 | 100000001-000010001-000010000 |

6

| | | |
|---|---|---|
| 8-6-A | 1000-0110-1010 | 100000001-000010001-000001000 |
| 8-6-B | 1000-0110-1011 | 100000001-000100010-001000000 |
| 8-6-C | 1000-0110-1100 | 100000001-000100010-000100000 |
| 8-6-D | 1000-0110-1101 | 100000001-000100010-000010000 |
| 8-6-E | 1000-0110-1110 | 100000001-000100010-000001000 |

| | | |
|---|---|---|
| 8-7 | 1000-0111 | 100000001-000000100 |
| | [ Dn-Dn+1-Dn+2 ] | [ Tn-TN+1-Tn+1 ] |
| 8-7-5 | 1000-0111-0101 | 100000001-000000001-000100000 |
| 8-7-6 | 1000-0111-1000 | 100000001-000010001-000100000 |
| 8-7-7 | 1000-0111-0111 | 100000001-000010001-000100000 |
| 8-7-8 | 1000-0111-1000 | 100000001-000000001-000010000 |
| 8-7-A | 1000-0111-1010 | 100000001-000000001-000001000 |
| 8-7-B | 1000-0111-1011 | 100000001-000000010-001000000 |
| 8-7-C | 1000-0111-1100 | 100000001-000000010-000100000 |
| 8-7-D | 1000-0111-1101 | 100000001-000000010-000010000 |
| 8-7-E | 1000-0111-1110 | 100000001-000000010-000001000 |
| 8-7-F | 1000-0110-1111 | 100000001-000010001-000100000 |

| | | |
|---|---|---|
| A | 1010 | 010000100 |

| | | |
|---|---|---|
| A-8 | 1010-1000 | 010000001-000100000 |
| A-D | 1010-1101 | 010000001-000010000 |
| A-F | 1010-1111 | 010000001-000001000 |

| | | |
|---|---|---|
| A-6 | 1010-0110 | 010000001-000000000 |

7

| | [ Dn-Dn+1-Dn+2 ] | [ Tn-TN+1-Tn+1 ] |
|---|---|---|
| A-6-5 | 1010-0110-0101 | 010000001-000010001-000100000 |
| A-6-8 | 1010-0110-1000 | 010000001-000010001-000010000 |
| A-6-A | 1010-0110-1010 | 010000001-000010001-000001000 |
| A-6-B | 1010-0110-1011 | 010000001-000100010-001000000 |
| A-6-C | 1010-0110-1100 | 010000001-000100010-000100000 |
| A-6-D | 1010-0110-1101 | 010000001-000100010-000010000 |
| A-6-E | 1010-0110-1110 | 010000001-000100010-000001000 |
| | | |
| A-7 | 1010-0111 | 010000001-000000100 |

| | [ Dn-Dn+1-Dn+2 ] | [ Tn-TN+1-Tn+1 ] |
|---|---|---|
| A-7-5 | 1010-0111-0101 | 010000001-000000001-000100000 |
| A-7-6 | 1010-0111-0110 | 010000001-000010001-000010000 |
| A-7-7 | 1010-0111-0111 | 010000001-000010001-000001000 |
| A-7-8 | 1010-0111-1000 | 010000001-000000001-000010000 |
| A-7-A | 1010-0111-1010 | 010000001-000000001-000001000 |
| A-7-B | 1010-0111-1011 | 010000001-000000010-001000000 |
| A-7-C | 1010-0111-1100 | 010000001-000000010-000100000 |
| A-7-D | 1010-0111-1101 | 010000001-000000010-000010000 |
| A-7-E | 1010-0111-1110 | 010000001-000000010-000001000 |
| A-7-F | 1010-0110-1111 | 010000001-000010001-000100000 |
| | | |
| B | 1011 | 001000100 |
| | | |
| B-8 | 1011-1000 | 001000001-000100000 |
| B-D | 1011-1101 | 001000001-000010000 |

B-F      1011-1111        001000001-000001000

B-6      1011-0110        001000001-000000000


[ Dn-Dn+1-Dn+2 ]          [ Tn-TN+1-Tn+1 ]

B-6-5    1011-0110-0101     001000001-000010001-000100000

B-6-8    1011-0110-1000     001000001-000010001-000010000

B-6-A    1011-0110-1010     001000001-000010001-000001000

B-6-B    1011-0110-1011     001000001-000100010-001000000

B-6-C    1011-0110-1100     001000001-000100010-000100000

B-6-D    1011-0110-1101     001000001-000100010-000010000

B-6-E    1011-0110-1110     001000001-000100010-000001000


B-7      1011-0111        001000001-000000100

[ Dn-Dn+1-Dn+2 ]          [ Tn-TN+1-Tn+1 ]

B-7-5    1011-0111-0101     001000001-000000001-000100000

B-7-6    1011-0111-0110     001000001-000010001-000010000

B-7-7    1011-0111-0111     001000001-000010001-000001000

B-7-8    1011-0111-1000     001000001-000000001-000010000

B-7-A    1011-0111-1010     001000001-000000001-000001000

B-7-B    1011-0111-1011     001000001-000000010-001000000

B-7-C    1011-0111-1100     001000001-000000010-000100000

B-7-D    1011-0111-1101     001000001-000000010-000010000

B-7-E    1011-0111-1110     001000001-000000010-000001000

B-7-F    1011-0110-1111     001000001-000010001-000100000


C       1100         001000010

```
C-DCC      1100-(DCC)      000X00001-000001000


C-0        1100-0000       000000001-000100000

C-8        1100-1000       000100001-000100000

C-9        1100-1001       000000001-000010000

C-A        1100-1010       000000001-000001000

C-D        1100-1101       000100001-000010000

C-F        1100-1111       000100001-000001000

                              .

C-6        1100-0110       000100001-000000000

       [ Dn-Dn+1-Dn+2 ]          [ Tn-TN+1-Tn+1 ]

C-6-5     1100-0110-0101   000100001-000010001-000100000

C-6-8     1100-0110-1000   000100001-000010001-000010000

C-6-A     1100-0110-1010   000100001-000010001-000001000

C-6-B     1100-0110-1011   000100001-000100010-001000000

C-6-C     1100-0110-1100   000100001-000100010-000100000

C-6-D     1100-0110-1101   000100001-000100010-000010000

C-6-E     1100-0110-1110   000100001-000100010-000001000


C-7        1100-0111       000100001-000000100

       [ Dn-Dn+1-Dn+2 ]          [ Tn-TN+1-Tn+1 ]

C-7-5     1100-0111-0101   000100001-000000001-000100000

C-7-6     1100-0111-0110   000100001-000100001-000010000

C-7-7     1100-0111-0111   000100001-000100001-000001000

C-7-8     1100-0111-1000   000100001-000000001-000010000

C-7-A     1100-0111-1010   000100001-000000001-000001000
```

| C-7-B | 1100-0111-1011 | 000100001-000000010-001000000 |
| C-7-C | 1100-0111-1100 | 000100001-000000010-000100000 |
| C-7-D | 1100-0111-1101 | 000100001-000000010-000010000 |
| C-7-E | 1100-0111-1110 | 000100001-000000010-000001000 |
| C-7-F | 1100-0110-1111 | 000100001-000010001-000100000 |
| | | |
| D | 1101 | 101000010 |
| | | |
| D-DCC | 1101-(DCC) | 010000010-000001000 |
| | | 100010001-000001000 |
| | | |
| D-0 | 1101-0000 | 010000010-000100000 |
| D-8 | 1101-1000 | 100100001-000100000 |
| D-9 | 1101-1001 | 010000010-000010000 |
| D-A | 1101-1010 | 010000010-000001000 |
| D-D | 1101-1101 | 100010001-000010000 |
| D-F | 1101-1111 | 100010001-000001000 |
| | | |
| D-6 | 1101-0110 | 100010001-000000000 |
| [ Dn-Dn+1-Dn+2 ] | | [ Tn-TN+1-Tn+1 ] |
| D-6-5 | 1101-0110-0101 | 100010001-000010001-000100000 |
| D-6-8 | 1101-0110-1000 | 000100001-000010001-000010000 |
| D-6-A | 1101-0110-1010 | 100010001-000010001-000001000 |
| D-6-B | 1101-0110-1011 | 100010001-000100010-001000000 |
| D-6-C | 1101-0110-1100 | 100010001-000100010-000100000 |
| D-6-D | 1101-0110-1101 | 100010001-000100010-000010000 |

| | | |
|---|---|---|
| D-6-E | 1101-0110-1110 | 100010001-000100010-000001000 |
| D-7 | 1101-0111 | 100010001-000000100 |
| | [ Dn-Dn+1-Dn+2 ] | [ Tn-TN+1-Tn+1 ] |
| D-7-5 | 1101-0111-0101 | 100010001-000000001-000100000 |
| D-7-6 | 1101-0111-0110 | 100010001-000100001-000010000 |
| D-7-7 | 1101-0111-0111 | 100010001-000100001-000001000 |
| D-7-8 | 1101-0111-1000 | 100010001-000000001-000010000 |
| D-7-A | 1101-0111-1010 | 100010001-000000001-000001000 |
| D-7-B | 1101-0111-1011 | 100010001-000000010-001000000 |
| D-7-C | 1101-0111-1100 | 100010001-000000010-000100000 |
| D-7-D | 1101-0111-1101 | 100010001-000000010-000010000 |
| D-7-E | 1101-0111-1110 | 100010001-000000010-000001000 |
| D-7-F | 1101-0110-1111 | 100010001-000010001-000100000 |
| E | 1110 | 101000010 |
| E-DCC | 1110-(DCC) | 000X00010-000001000 |
| E-0 | 1110-0000 | 000000000-000100000 |
| E-8 | 1110-1000 | 000000010-000100000 |
| E-9 | 1110-1001 | 000000000-000010000 |
| E-A | 1110-1010 | 000000000-000001000 |
| E-D | 1110-1101 | 000000010-000010000 |
| E-F | 1110-1111 | 000000010-000001000 |

12

| | | |
|---|---|---|
| E-6 | 1110-0110 | 000000010-000000000 |
| | [ Dn-Dn+1-Dn+2 ] | [ Tn-TN+1-Tn+1 ] |
| E-6-5 | 1110-0110-0101 | 000010001-000010001-000100000 |
| E-6-8 | 1110-0110-1000 | 000100001-000010001-000010000 |
| E-6-A | 1110-0110-1010 | 000010001-000010001-000001000 |
| E-6-B | 1110-0110-1011 | 000010001-000100010-001000000 |
| E-6-C | 1110-0110-1100 | 000010001-000100010-000100000 |
| E-6-D | 1110-0110-1101 | 000010001-000100010-000010000 |
| E-6-E | 1110-0110-1110 | 000010001-000100010-000001000 |

| | | |
|---|---|---|
| E-7 | 1110-0111 | 000010001-000000100 |
| | [ Dn-Dn+1-Dn+2 ] | [ Tn-TN+1-Tn+1 ] |
| E-7-5 | 1110-0111-0101 | 000010001-000000001-000100000 |
| E-7-6 | 1110-0111-0110 | 000010001-000100001-000010000 |
| E-7-7 | 1110-0111-0111 | 000010001-000100001-000001000 |
| E-7-8 | 1110-0111-1000 | 000010001-000000001-000010000 |
| E-7-A | 1110-0111-1010 | 000010001-000000001-000001000 |
| E-7-B | 1110-0111-1011 | 000010001-000000010-001000000 |
| E-7-C | 1110-0111-1100 | 000010001-000000010-000100000 |
| E-7-D | 1110-0111-1101 | 000010001-000000010-000010000 |
| E-7-E | 1110-0111-1110 | 000010001-000000010-000001000 |
| E-7-F | 1110-0110-1111 | 000010001-000010001-000100000 |

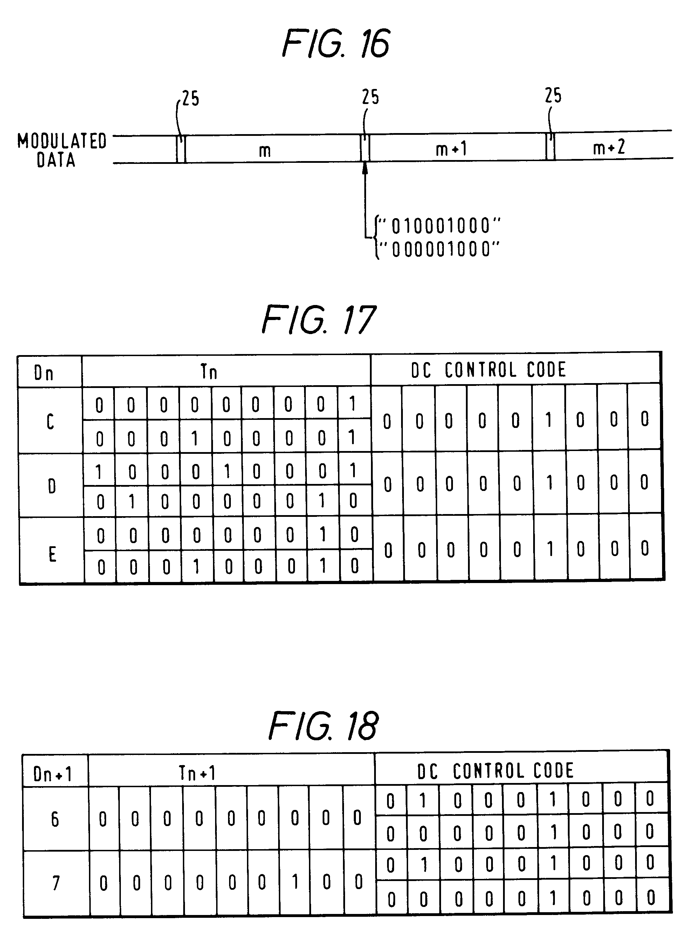

In the next place, the DSV process will be explained. In the embodiment described in FIGURES 1 through 11, no process is executed to minimize the DSV. As a modulation system for minimizing the DSV may be demanded for some applications, the DSV process method used in the present invention will be explained. A system to insert a specific code (DC control code 25) at a fixed interval is shown in FIGURE 16. Here, although the less the number of bits of an inserting code, the better, taking an easy processing into consideration, a nine-bit code-word in the same size as a conversion code length will be explained.

DC control code 25 is available in two kinds: "010001000" and "000001000", and a pattern for making DSV smaller is selected and inserted. To be concrete, for DC control code 25 to be inserted after (m)-series data, a pattern for making DSV smaller is finally selected by calculating DSV up to the next (m+1)-series data. However, the "010001000" pattern cannot be inserted arbitrarily. For instance, after the "00100010" pattern among three conversion codes corresponding to Dn = C, the number of continuous bits of "0" will become two at the connecting point of both codes, so that the conversion rule cannot be satisfied. As a measure for preventing the problem, DC control code 25 is inserted after a data value of Dn = C, D or E, before the conversion is fixed to "000001000". Then an appropriate value of the pattern E, as shown in FIGURE 17, is selected for the Tn

13

pattern corresponding to C, D instead of a conversion pattern shown in the table in FIGURE 1.

Further, when a second code is restricted by the next code, that is, when Dn+1 = 6, 7, the nine-bit patterns "000000000" and "000000100" are adopted as patterns corresponding to the conversion code Tn+1 for DC control code 25 according to a table, as shown in FIGURE 18.

Further, it is also possible to use seven-bit patterns "0001000" and "0000000" for DC control code 25. If there is a conversion pattern having long lasting bits of "0", before and after the seven-bit pattern "0000000", the maximum inversion interval Tmax becomes two long. Therefore in this case, a bit pattern "0001000" will be selected. In any case, it is better to adopt an inserting method meeting a purpose and this control code insertion is a very effective method for preventing not only a decline of DSV but also error propagation.

In this embodiment, it is an object to prevent a state where less than two continuous bits "0" is generated between modulated code-words to be continuously converted, and the minimum inversion interval Tmin becomes (4x4/9)T = 1.78T and the detection window width Tw becomes (4/9)T = 1.44T. As a result, it becomes possible to realize the high density recording of disc.

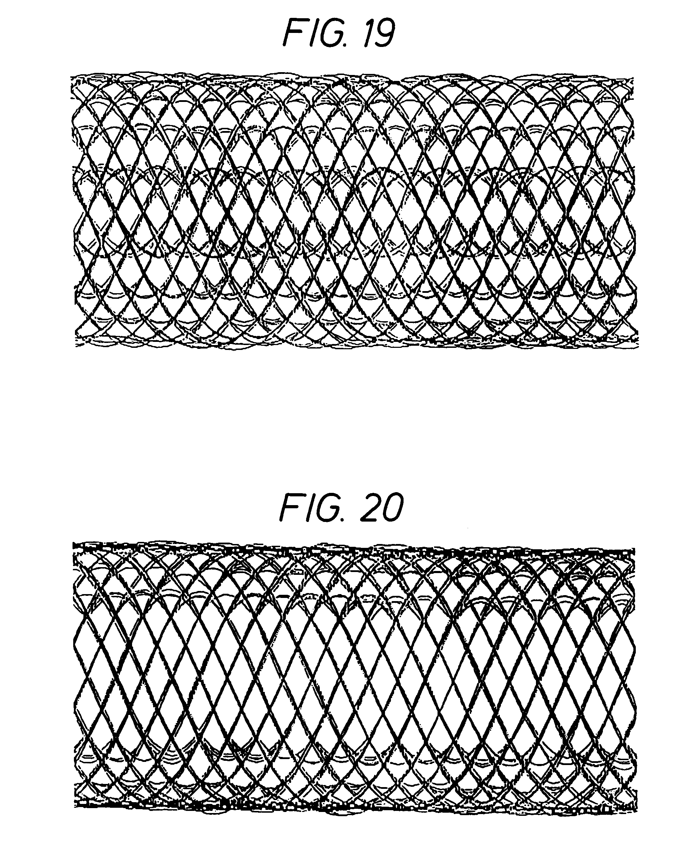

Next, the result of comparison test of the [4,9] modulation system of the present invention with the conventional EFM modulation system conducted based on the embodiment described above is shown in FIGURES 19 and 20.

FIGURES 19 and 20 are graphs showing the eye pattern characteristics of reproduced signal according to the conventional EFM modulation system and the eye pattern characteristic according to the [4,9] modulation system according to the present invention, respectively. Further, these characteristic graphs show the test results conducted under the conditions of the bit length Tp = 0.725 mm, the minimum inversion interval of the former Tmin(A) = 360 mm and the minimum inversion interval of the latter Tmin(B) = 480 mm to get the same recording density (4 gigabyte recording capacity). As can be seen from the comparison of FIGURES 19 and 20, the eye pattern (FIGURE 20) of the reproduced signal according to the [4,9] modulation system of the present invention has an amplitude larger than the eye pattern (FIGURE 19) according to the conventional EFM modulation system and it is therefore expected that read errors will be reduced extremely.

One embodiment of the present invention has been described above with reference to the drawings. The present invention, however, is not limited to the tables shown in FIGURES 1 through 4, FIGURES 7 thtough 11, FIGURES 13 through 15, and FIGURES 17 and 18.

The pattern of a conversion code T corresponding to an input code data "D" has no inevitability and is variable in many ways and, for instance, Dn = 0 and Dn = 1 or Dn = 8 and Dn = F can be exchanged each other. In this embodiment, a code length was restricted to maximum three codes in some cases but there will be no problem even when it is extended to four codes or limited to less than two codes. In short, it is satisfactory if the minimum inversion interval Tmin in four channel bit length, that is, Tmin = 1.41T is realized after NRZI by combining 26 kinds of nine-bit code-words containing minimum three bits of "0" between both a preceeding bit and its following bit of "1".

As described above, according to the present invention can provide an extremely preferable digitl data modulation/demodulation sustem, which is able to prevent the generation of a state containing less than 3 continuous bits "0" between modulated code-words to be continuously converted, it is possible to make the minimum inversion interval Tmin large, thus realizing a large capacity optical disc with improved recording density.

While there have been illustrated and described what are at present considered to be preferred embodiments of the present invention, it will be understood by those skilled in the art that various changes and modifications may be made, and equivalents may be substituted for elements thereof without departing from the true scope of the present invention. In addition, many modifications may be made to adapt a particular situation or material to the teaching of the present invention without departing from the central scope thereof. Therefor, it is intended that the present invention not be limited to the particular embodiment disclosed as the best mode contemplated for carrying out the present invention, but that the present invention includes all embodiments falling within the scope of the appended claims.

The foregoing description and the drawings are regarded by the applicant as including a variety of individually inventive concepts, some of which may lie partially or wholly outside the scope of some or all of the following claims. The fact that the applicant has chosen at the time of filing of the present application to restrict the claimed scope of protection in accordance with the following claims is not to be taken as a disclaimer or alternative inventive concepts that are included in the contents of the application and could be defined by claims differing in scope from the following claims, which different claims may be adopted subsequently during prosecution, for example, for the purposes of a divisional application.

## Claims

1. A modulation system comprising:

   a separator for separating a consecutive binary data sequence to four-bit code-words;

   a four-to-nine ([4,9]) converter for converting the four-bit code-words into nine-bit modulated code-words; and

   a code selector for selecting a code among nine-bit codes containing minimum three bits "0" between a first bit "1" and a following second bit "1" so that there should not be less than two consecutive bits "0" between a selecting code and a modulated code-word which is to be converted next by the [4,9] converter.

2. A data modulation system claimed in the claim 1, characterised in that it is further provided with a specific code inserting means for inserting a specific code into the modulated code-word sequence at a prescribed interval.

3. A data demodulation system comprising:

   a restoration means for restoring a consecutive modulated code-word sequence into four-bit code-words;

   and a conversion rule updating means for updating conversion rules for modulated code-words up to the Nth (N = positive integer; 1, 2, ...) modulated code-word that are consecutively input when a modulated code-word having a specific pattern comes to appear.

4. A data demodulation system claimed in the claim 3, characterized in that it is further provided with a conversion rule restoring means for restoring the conversion rules for modulation codes to the initial state at every prescribed interval or whenever detecting a specific code when demodulating a modulated code-word sequence with a specific code inserted at a prescribed interval in the restoration means.

5. A data modulator comprising:

   a separator for separating a consecutive binary data sequence to four-bit code-words;

   a four-to-nine ([4,9]) converter for converting the separated four-bit code-word into a nine-bit modulated code-word; and

   a code selector for selecting a code among nine-bit code-eords containing minimum three bits "0" between a first bit "1" and a following second bit "1" so that there should not be less than two consecutive bits "0" between a selecting code and a modulated code-word which is to be converted next by the [4,9] converter.

6. A data modulator claimed in the claim 5, characterized in that it is further provided with a specific code inserting means for inserting a specific code into the modulated code-word sequence at a prescribed interval.

7. A data demodulator comprising:

   a restoration means for restoring the consecutive modulated code-word into four-bit code-words by separating it every nine bits;

   and a conversion rule updating means for updating conversion rules for modulated code-words up to the Nth (N = positive integer; 1, 2, ...) modulated code-word that are consecutively input if a modulated code-word having a specific pattern comes to appear in the restoration means.

8. A data demodulator claimed in the claim 7, characterized in that it is further provided with a conversion rule restoration means for modulated code-words at a prescribed interval or whenever detecting a specific code when demodulating a modulated code-word sequence with a specific code inserted at a prescribed interval.

# FIG. 1

| Dn | Tn | CONDITION BY Dn+1 |
|----|-----------|----------------------------|
| 0 | 010000000 | |
| 1 | 001000000 | |
| 2 | 000100000 | |
| 3 | 000010000 | |
| 4 | 000001000 | |
| 5 | 000000100 | EXCEPT (6.7.8.D.F) |
| | 000010001 | (6.7.8.D.F) CASE (1) |
| 6 | 100010000 | |
| 7 | 100001000 | |
| 8 | 100000100 | EXCEPT (6.7.8.D.F) |
| | 100000001 | (6.7.8.D.F)···(SEE FIG.2) |
| 9 | 010001000 | |
| A | 010000100 | EXCEPT (6.7.8.D.F) |
| | 010000001 | (6.7.8.D.F)···(SEE FIG.2) |
| B | 001000100 | EXCEPT (6.7.8.D.F) |
| | 001000001 | (6.7.8.D.F) CASE (1) |
| C | 001000010 | EXCEPT (0.6.7.8.9.A.D.F) |
| | 000100001 | (6.7.8.D.F)···(SEE FIG.2) |
| | 000000001 | (0.9.A)···(SEE FIG.3) |
| D | 100000010 | EXCEPT (0.6.7.8.9.A.D.F) |
| | 100010001 | (6.7.8.D.F)···(SEE FIG.2) |
| | 010000010 | (0.9.A)···(SEE FIG.3) |
| E | 000100010 | EXCEPT (0.6.7.8.9.A.D.F) |
| | 000000010 | (6.7.8.D.F)···(SEE FIG.2) |
| | 000000000 | (0.9.A)···(SEE FIG.4) |
| F | 100000000 | |

FIG. 2

| Dn+1 | Tn+1 | Dn+2 | Tn+2 |
|---|---|---|---|
| 6 | 000000000 | F | 100000000 |
| | | 0 | 010000000 |
| | | 1 | 001000000 |
| | | 2 | 000100000 |
| | | 3 | 000010000 |
| | | 4 | 000001000 |
| | | 6 | 100010000 |
| | | 7 | 100001000 |
| | | 9 | 010001000 |
| | 000100010 | B | 001000000 |
| | | C | 000100000 |
| | | D | 000010000 |
| | | E | 000001000 |
| | 000010001 | 5 | 000100000 |
| | | 8 | 000010000 |
| | | A | 000001000 |
| 7 | 000000100 | 0 | 010000000 |
| | | 1 | 001000000 |
| | | 2 | 000100000 |
| | | 3 | 000010000 |
| | | 4 | 000001000 |
| | | 9 | 010001000 |
| | 000000010 | B | 001000000 |
| | | C | 000100000 |
| | | D | 000010000 |
| | | E | 000001000 |
| | 000000001 | 5 | 000100000 |
| | | 8 | 000010000 |
| | | A | 000001000 |
| | 000100001 | 6 | 000010000 |
| | | 7 | 000001000 |
| | | F | 000100000 |
| 8 | 000100000 | | |
| D | 000010000 | | |
| F | 000001000 | | |

## FIG. 3

| | |
|---|---|
| 0 | 000100000 |
| 9 | 000010000 |
| A | 000001000 |

## FIG. 4

| | |
|---|---|
| 0 | 100000000 |
| 9 | 100010000 |
| A | 100001000 |

## FIG. 11

TRUTH TABLE OF TLGC(e)

| d3 | d2 | d1 | d0 | SL1 | t8 | t7 | t6 | t5 | t4 | t3 | t2 | t1 | t0 |
|---|---|---|---|---|---|---|---|---|---|---|---|---|---|
| 0 | 0 | 0 | 0 | * | 0 | 1 | 0 | 0 | 0 | 0 | 0 | 0 | 0 |
| 0 | 0 | 0 | 1 | * | 0 | 0 | 1 | 0 | 0 | 0 | 0 | 0 | 0 |
| 0 | 0 | 1 | 0 | * | 0 | 0 | 0 | 1 | 0 | 0 | 0 | 0 | 0 |
| 0 | 0 | 1 | 1 | * | 0 | 0 | 0 | 0 | 1 | 0 | 0 | 0 | 0 |
| 0 | 1 | 0 | 0 | * | 0 | 0 | 0 | 0 | 0 | 1 | 0 | 0 | 0 |
| 0 | 1 | 0 | 1 | * | 0 | 0 | 0 | 1 | 0 | 0 | 0 | 0 | 0 |
| 0 | 1 | 1 | 0 | 0 | 1 | 0 | 0 | 0 | 1 | 0 | 0 | 0 | 0 |
| 0 | 1 | 1 | 0 | 1 | 0 | 0 | 0 | 0 | 1 | 0 | 0 | 0 | 0 |
| 0 | 1 | 1 | 1 | 0 | 1 | 0 | 0 | 0 | 0 | 1 | 0 | 0 | 0 |
| 0 | 1 | 1 | 1 | 1 | 0 | 0 | 0 | 0 | 0 | 1 | 0 | 0 | 0 |
| 1 | 0 | 0 | 0 | * | 0 | 0 | 0 | 0 | 1 | 0 | 0 | 0 | 0 |
| 1 | 0 | 0 | 1 | * | 0 | 1 | 0 | 0 | 0 | 1 | 0 | 0 | 0 |
| 1 | 0 | 1 | 0 | * | 0 | 0 | 0 | 0 | 0 | 1 | 0 | 0 | 0 |
| 1 | 0 | 1 | 1 | * | 0 | 0 | 1 | 0 | 0 | 0 | 0 | 0 | 0 |
| 1 | 1 | 0 | 0 | * | 0 | 0 | 0 | 1 | 0 | 0 | 0 | 0 | 0 |
| 1 | 1 | 0 | 1 | * | 0 | 0 | 0 | 0 | 1 | 0 | 0 | 0 | 0 |
| 1 | 1 | 1 | 0 | * | 0 | 0 | 0 | 0 | 0 | 1 | 0 | 0 | 0 |
| 1 | 1 | 1 | 1 | 0 | 1 | 0 | 0 | 0 | 0 | 0 | 0 | 0 | 0 |
| 1 | 1 | 1 | 1 | 1 | 0 | 0 | 0 | 1 | 0 | 0 | 0 | 0 | 0 |

FIG. 5

FIG. 5 (CONTD)

SEL

TLGC
(d)

t0 t1 t2 t3 t4 t5 t6 t7 t8

TLGC
(c)

t0 t1 t2 t3 t4 t5 t6 t7 t8

TLGC
(d)

t0
t1
t2
t3
t4
t5
t6
t7
t8

*FIG. 6*

# FIG. 7

### TRUTH TABLE OF TLGC (d)

| d3 | d2 | d1 | d0 | SL1 | SL2 | t8 | t7 | t6 | t5 | t4 | t3 | t2 | t1 | t0 | SF1 |
|----|----|----|----|-----|-----|----|----|----|----|----|----|----|----|----|-----|
| 0 | 0 | 0 | 0 | * | * | 0 | 1 | 0 | 0 | 0 | 0 | 0 | 0 | 0 | 0 |
| 0 | 0 | 0 | 1 | * | * | 0 | 0 | 1 | 0 | 0 | 0 | 0 | 0 | 0 | 0 |
| 0 | 0 | 1 | 0 | * | * | 0 | 0 | 0 | 1 | 0 | 0 | 0 | 0 | 0 | 0 |
| 0 | 0 | 1 | 1 | * | * | 0 | 0 | 0 | 0 | 1 | 0 | 0 | 0 | 0 | 0 |
| 0 | 1 | 0 | 0 | * | * | 0 | 0 | 0 | 0 | 0 | 1 | 0 | 0 | 0 | 0 |
| 0 | 1 | 0 | 1 | 0 | * | 0 | 0 | 0 | 0 | 0 | 0 | 1 | 0 | 0 | 0 |
| 0 | 1 | 0 | 1 | 1 | 0 | 0 | 0 | 0 | 0 | 1 | 0 | 0 | 0 | 1 | 1 |
| 0 | 1 | 1 | 0 | * | * | 1 | 0 | 0 | 0 | 1 | 0 | 0 | 0 | 0 | 0 |
| 0 | 1 | 1 | 1 | * | * | 1 | 0 | 0 | 0 | 0 | 1 | 0 | 0 | 0 | 0 |
| 1 | 0 | 0 | 0 | 0 | * | 1 | 0 | 0 | 0 | 0 | 0 | 1 | 0 | 0 | 0 |
| 1 | 0 | 0 | 0 | 1 | 0 | 1 | 0 | 0 | 0 | 0 | 0 | 0 | 0 | 1 | 1 |
| 1 | 0 | 0 | 1 | * | * | 0 | 1 | 0 | 0 | 0 | 1 | 0 | 0 | 0 | 0 |
| 1 | 0 | 1 | 0 | 0 | * | 0 | 1 | 0 | 0 | 0 | 0 | 1 | 0 | 0 | 0 |
| 1 | 0 | 1 | 0 | 1 | 0 | 0 | 1 | 0 | 0 | 0 | 0 | 0 | 0 | 1 | 1 |
| 1 | 0 | 1 | 1 | 0 | * | 0 | 0 | 1 | 0 | 0 | 0 | 1 | 0 | 0 | 0 |
| 1 | 0 | 1 | 1 | 1 | 0 | 0 | 0 | 1 | 0 | 0 | 0 | 0 | 0 | 1 | 1 |
| 1 | 1 | 0 | 0 | 0 | 0 | 0 | 0 | 0 | 1 | 0 | 0 | 0 | 1 | 0 | 0 |
| 1 | 1 | 0 | 0 | 1 | 0 | 0 | 0 | 0 | 1 | 0 | 0 | 0 | 0 | 1 | 1 |
| 1 | 1 | 0 | 0 | 0 | 1 | 0 | 0 | 0 | 0 | 0 | 0 | 0 | 0 | 1 | 1 |
| 1 | 1 | 0 | 1 | 0 | 0 | 1 | 0 | 0 | 0 | 0 | 0 | 0 | 1 | 0 | 0 |
| 1 | 1 | 0 | 1 | 1 | 0 | 1 | 0 | 0 | 0 | 1 | 0 | 0 | 0 | 1 | 1 |
| 1 | 1 | 0 | 1 | 0 | 1 | 0 | 1 | 0 | 0 | 0 | 0 | 0 | 1 | 0 | 1 |
| 1 | 1 | 1 | 0 | 0 | 0 | 0 | 0 | 1 | 0 | 0 | 0 | 0 | 1 | 0 | 0 |
| 1 | 1 | 1 | 0 | 1 | 0 | 0 | 0 | 0 | 0 | 0 | 0 | 0 | 1 | 0 | 1 |
| 1 | 1 | 1 | 0 | 0 | 1 | 0 | 0 | 0 | 0 | 0 | 0 | 0 | 0 | 0 | 1 |
| 1 | 1 | 1 | 1 | * | * | 1 | 0 | 0 | 0 | 0 | 0 | 0 | 0 | 0 | 0 |

(SL1 & SL2 --- NOT TAKE "1" SIMULTANEOUSLY)

## FIG. 8

TRUTH TABLE OF T L G C (b)

| d3 | d2 | d1 | d0 | SL3 | SL4 | SL5 | t8 | t7 | t6 | t5 | t4 | t3 | t2 | t1 | t0 | SP2 |
|----|----|----|----|-----|-----|-----|----|----|----|----|----|----|----|----|----|-----|
| 0 | 1 | 1 | 0 | 0 | 0 | * | 0 | 0 | 0 | 0 | 0 | 0 | 0 | 0 | 0 | 1 |
| 0 | 1 | 1 | 0 | 1 | 0 | 0 | 0 | 0 | 0 | 1 | 0 | 0 | 0 | 1 | 0 | 1 |
| 0 | 1 | 1 | 0 | 0 | 1 | 0 | 0 | 0 | 0 | 0 | 1 | 0 | 0 | 0 | 1 | 1 |
| 0 | 1 | 1 | 1 | 0 | 0 | 0 | 0 | 0 | 0 | 0 | 0 | 0 | 1 | 0 | 0 | 1 |
| 0 | 1 | 1 | 1 | 1 | 0 | 0 | 0 | 0 | 0 | 0 | 0 | 0 | 0 | 1 | 0 | 1 |
| 0 | 1 | 1 | 1 | 0 | 1 | 0 | 0 | 0 | 0 | 0 | 0 | 0 | 0 | 0 | 1 | 1 |
| 0 | 1 | 1 | 1 | 0 | 0 | 1 | 0 | 0 | 0 | 1 | 0 | 0 | 0 | 0 | 1 | 1 |
| EXCEPT ABOVE | | | | | | | 0 | 0 | 0 | 0 | 0 | 0 | 0 | 0 | 0 | 0 |

## FIG. 9

TRUTH TABLE OF T L G C (c)

| d3 | d2 | d1 | d0 | t8 | t7 | t6 | t5 | t4 | t3 | t2 | t1 | t0 |
|----|----|----|----|----|----|----|----|----|----|----|----|----|
| 1 | 0 | 0 | 0 | 0 | 0 | 0 | 1 | 0 | 0 | 0 | 0 | 0 |
| 1 | 1 | 0 | 1 | 0 | 0 | 0 | 0 | 1 | 0 | 0 | 0 | 0 |
| 1 | 1 | 1 | 1 | 0 | 0 | 0 | 0 | 0 | 1 | 0 | 0 | 0 |
| | | | | 0 | 0 | 0 | 0 | 0 | 0 | 0 | 0 | 0 |

## FIG. 10

TRUTH TABLE OF T L G C (d)

| d3 | d2 | d1 | d0 | SL6 | t8 | t7 | t6 | t5 | t4 | t3 | t2 | t1 | t0 |
|----|----|----|----|-----|----|----|----|----|----|----|----|----|----|
| 0 | 0 | 0 | 0 | 0 | 0 | 0 | 0 | 1 | 0 | 0 | 0 | 0 | 0 |
| 0 | 0 | 0 | 0 | 1 | 1 | 0 | 0 | 0 | 0 | 0 | 0 | 0 | 0 |
| 1 | 0 | 0 | 1 | 0 | 0 | 0 | 0 | 0 | 1 | 0 | 0 | 0 | 0 |
| 1 | 0 | 0 | 1 | 1 | 1 | 0 | 0 | 0 | 1 | 0 | 0 | 0 | 0 |
| 1 | 0 | 1 | 0 | 0 | 0 | 0 | 0 | 0 | 0 | 1 | 0 | 0 | 0 |
| 1 | 0 | 1 | 0 | 1 | 1 | 0 | 0 | 0 | 0 | 1 | 0 | 0 | 0 |
| | | | | | 0 | 0 | 0 | 0 | 0 | 0 | 0 | 0 | 0 |

# FIG. 12

# FIG. 13

TRUTH TABLE OF TLGC (f)

| t8 | t7 | t6 | t5 | t4 | t3 | t2 | t1 | t0 | d3 | d2 | d1 | d0 | SL1 | SF1 |
|----|----|----|----|----|----|----|----|----|----|----|----|----|-----|-----|
| 0 | 1 | 0 | 0 | 0 | 0 | 0 | 0 | 0 | 0 | 0 | 0 | 0 | 0 | 0 |
| 0 | 0 | 1 | 0 | 0 | 0 | 0 | 0 | 0 | 0 | 0 | 0 | 1 | 0 | 0 |
| 0 | 0 | 0 | 1 | 0 | 0 | 0 | 0 | 0 | 0 | 0 | 1 | 0 | 0 | 0 |
| 0 | 0 | 0 | 0 | 1 | 0 | 0 | 0 | 0 | 0 | 0 | 1 | 1 | 0 | 0 |
| 0 | 0 | 0 | 0 | 0 | 1 | 0 | 0 | 0 | 0 | 1 | 0 | 0 | 0 | 0 |
| 0 | 0 | 0 | 0 | 0 | 0 | 1 | 0 | 0 | 0 | 1 | 0 | 1 | 0 | 0 |
| 0 | 0 | 0 | 0 | 1 | 0 | 0 | 0 | 1 | 0 | 1 | 0 | 1 | 0 | 1 |
| 1 | 0 | 0 | 0 | 1 | 0 | 0 | 0 | 0 | 0 | 1 | 1 | 0 | 0 | 0 |
| 1 | 0 | 0 | 0 | 0 | 1 | 0 | 0 | 0 | 0 | 1 | 1 | 1 | 0 | 0 |
| 1 | 0 | 0 | 0 | 0 | 0 | 1 | 0 | 0 | 1 | 0 | 0 | 0 | 0 | 0 |
| 1 | 0 | 0 | 0 | 0 | 0 | 0 | 0 | 1 | 1 | 0 | 0 | 0 | 0 | 1 |
| 0 | 1 | 0 | 0 | 0 | 1 | 0 | 0 | 0 | 1 | 0 | 0 | 1 | 0 | 0 |
| 0 | 1 | 0 | 0 | 0 | 0 | 1 | 0 | 0 | 1 | 0 | 1 | 0 | 0 | 0 |
| 0 | 1 | 0 | 0 | 0 | 0 | 0 | 0 | 1 | 1 | 0 | 1 | 0 | 0 | 1 |
| 0 | 0 | 1 | 0 | 0 | 0 | 1 | 0 | 0 | 1 | 0 | 1 | 1 | 0 | 0 |
| 0 | 0 | 1 | 0 | 0 | 0 | 0 | 0 | 1 | 1 | 0 | 1 | 1 | 0 | 1 |
| 0 | 0 | 1 | 0 | 0 | 0 | 0 | 1 | 0 | 1 | 1 | 0 | 0 | 0 | 0 |
| 0 | 0 | 0 | 1 | 0 | 0 | 0 | 0 | 1 | 1 | 1 | 0 | 0 | 0 | 1 |
| 0 | 0 | 0 | 0 | 0 | 0 | 0 | 0 | 1 | 1 | 1 | 0 | 0 | 1 | 1 |
| 1 | 0 | 0 | 0 | 0 | 0 | 0 | 1 | 0 | 1 | 1 | 0 | 1 | 0 | 0 |
| 1 | 0 | 0 | 0 | 1 | 0 | 0 | 0 | 1 | 1 | 1 | 0 | 1 | 0 | 1 |
| 0 | 1 | 0 | 0 | 0 | 0 | 0 | 1 | 0 | 1 | 1 | 0 | 1 | 1 | 1 |
| 0 | 0 | 0 | 1 | 0 | 0 | 0 | 1 | 0 | 1 | 1 | 1 | 0 | 0 | 0 |
| 0 | 0 | 0 | 0 | 0 | 0 | 0 | 1 | 0 | 1 | 1 | 1 | 0 | 0 | 1 |
| 0 | 0 | 0 | 0 | 0 | 0 | 0 | 0 | 0 | 1 | 1 | 1 | 0 | 1 | 1 |
| 1 | 0 | 0 | 0 | 0 | 0 | 0 | 0 | 0 | 1 | 1 | 1 | 1 | 0 | 0 |

## FIG. 14

### TRUTH TABLE OF TLGC(g)

| t8 | t7 | t6 | t5 | t4 | t3 | t2 | t1 | t0 | SL1 | d3 | d2 | d1 | d0 | SL2 | SL3 | SL4 | SF2 |
|----|----|----|----|----|----|----|----|----|-----|----|----|----|----|-----|-----|-----|-----|
| 0 | 0 | 0 | 0 | 0 | 0 | 0 | 0 | 0 | 0 | 0 | 1 | 1 | 0 | 0 | 0 | 0 | 1 |
| 0 | 0 | 0 | 1 | 0 | 0 | 0 | 1 | 0 | 0 | 0 | 1 | 1 | 0 | 1 | 0 | 0 | 1 |
| 0 | 0 | 0 | 0 | 1 | 0 | 0 | 0 | 1 | 0 | 0 | 1 | 1 | 0 | 0 | 1 | 0 | 1 |
| 0 | 0 | 0 | 0 | 0 | 0 | 1 | 0 | 0 | 0 | 0 | 1 | 1 | 1 | 0 | 0 | 0 | 1 |
| 0 | 0 | 0 | 0 | 0 | 0 | 0 | 1 | 0 | 0 | 0 | 1 | 1 | 1 | 1 | 0 | 0 | 1 |
| 0 | 0 | 0 | 0 | 0 | 0 | 0 | 0 | 1 | 0 | 0 | 1 | 1 | 1 | 0 | 1 | 0 | 1 |
| 0 | 0 | 0 | 1 | 0 | 0 | 0 | 0 | 1 | 0 | 0 | 1 | 1 | 1 | 0 | 0 | 1 | 1 |
| 0 | 0 | 0 | 1 | 0 | 0 | 0 | 0 | 0 | 0 | 1 | 0 | 0 | 0 | 0 | 0 | 0 | 0 |
| 0 | 0 | 0 | 0 | 1 | 0 | 0 | 0 | 0 | 0 | 1 | 1 | 0 | 1 | 0 | 0 | 0 | 0 |
| 0 | 0 | 0 | 0 | 0 | 1 | 0 | 0 | 0 | 0 | 1 | 1 | 1 | 1 | 0 | 0 | 0 | 0 |
| 0 | 0 | 0 | 1 | 0 | 0 | 0 | 0 | 0 | 1 | 0 | 0 | 0 | 0 | 0 | 0 | 0 | 0 |
| 1 | 0 | 0 | 0 | 0 | 0 | 0 | 0 | 0 | 1 | 0 | 0 | 0 | 0 | 0 | 0 | 0 | 0 |
| 0 | 0 | 0 | 0 | 1 | 0 | 0 | 0 | 0 | 1 | 1 | 0 | 0 | 1 | 0 | 0 | 0 | 0 |
| 1 | 0 | 0 | 0 | 1 | 0 | 0 | 0 | 0 | 1 | 1 | 0 | 0 | 1 | 0 | 0 | 0 | 0 |
| 0 | 0 | 0 | 0 | 0 | 1 | 0 | 0 | 0 | 1 | 1 | 0 | 1 | 0 | 0 | 0 | 0 | 0 |
| 1 | 0 | 0 | 0 | 0 | 1 | 0 | 0 | 0 | 1 | 1 | 0 | 1 | 0 | 0 | 0 | 0 | 0 |

# FIG. 15

## TRUTH TABLE OF TLGC(h)

| t8 | t7 | t6 | t5 | t4 | t3 | t2 | t1 | t0 | SL2 | SL3 | SL4 | d3 | d2 | d1 | d0 |
|----|----|----|----|----|----|----|----|----|-----|-----|-----|----|----|----|----|
| 0 | 1 | 0 | 0 | 0 | 0 | 0 | 0 | 0 | 0 | 0 | 0 | 0 | 0 | 0 | 0 |
| 0 | 0 | 1 | 0 | 0 | 0 | 0 | 0 | 0 | 0 | 0 | 0 | 0 | 0 | 0 | 1 |
| 0 | 0 | 0 | 1 | 0 | 0 | 0 | 0 | 0 | 0 | 0 | 0 | 0 | 0 | 1 | 0 |
| 0 | 0 | 0 | 0 | 1 | 0 | 0 | 0 | 0 | 0 | 0 | 0 | 0 | 0 | 1 | 1 |
| 0 | 0 | 0 | 0 | 0 | 1 | 0 | 0 | 0 | 0 | 0 | 0 | 0 | 1 | 0 | 0 |
| 0 | 1 | 0 | 0 | 0 | 1 | 0 | 0 | 0 | 0 | 0 | 0 | 1 | 0 | 0 | 1 |
| 0 | 0 | 1 | 0 | 0 | 0 | 0 | 0 | 0 | 1 | 0 | 0 | 1 | 0 | 1 | 1 |
| 0 | 0 | 0 | 1 | 0 | 0 | 0 | 0 | 0 | 1 | 0 | 0 | 1 | 1 | 0 | 0 |
| 0 | 0 | 0 | 0 | 1 | 0 | 0 | 0 | 0 | 1 | 0 | 0 | 1 | 1 | 0 | 1 |
| 0 | 0 | 0 | 0 | 0 | 1 | 0 | 0 | 0 | 1 | 0 | 0 | 1 | 1 | 1 | 0 |
| 0 | 0 | 0 | 1 | 0 | 0 | 0 | 0 | 0 | 0 | 1 | 0 | 0 | 1 | 0 | 1 |
| 0 | 0 | 0 | 0 | 1 | 0 | 0 | 0 | 0 | 0 | 1 | 0 | 1 | 0 | 0 | 0 |
| 0 | 0 | 0 | 0 | 0 | 1 | 0 | 0 | 0 | 0 | 1 | 0 | 1 | 0 | 1 | 0 |
| 1 | 0 | 0 | 0 | 1 | 0 | 0 | 0 | 0 | 0 | 0 | 1 | 0 | 1 | 1 | 0 |
| 0 | 0 | 0 | 0 | 1 | 0 | 0 | 0 | 0 | 0 | 0 | 1 | 0 | 1 | 1 | 0 |
| 1 | 0 | 0 | 0 | 0 | 1 | 0 | 0 | 0 | 0 | 0 | 1 | 0 | 1 | 1 | 1 |
| 0 | 0 | 0 | 0 | 0 | 1 | 0 | 0 | 0 | 0 | 0 | 1 | 0 | 1 | 1 | 1 |
| 1 | 0 | 0 | 0 | 0 | 0 | 0 | 0 | 0 | 0 | 0 | 1 | 1 | 1 | 1 | 1 |
| 0 | 0 | 0 | 1 | 0 | 0 | 0 | 0 | 0 | 0 | 0 | 1 | 1 | 1 | 1 | 1 |

## FIG. 16

MODULATED DATA: | 25 | m | 25 | m+1 | 25 | m+2 |

{"010001000"
{"000001000"

## FIG. 17

| Dn | Tn | | | | | | | | | DC CONTROL CODE | | | | | | | | |
|----|---|---|---|---|---|---|---|---|---|---|---|---|---|---|---|---|---|---|
| C | 0 | 0 | 0 | 0 | 0 | 0 | 0 | 0 | 1 | 0 | 0 | 0 | 0 | 0 | 1 | 0 | 0 | 0 |
|   | 0 | 0 | 0 | 1 | 0 | 0 | 0 | 0 | 1 | | | | | | | | | |
| D | 1 | 0 | 0 | 0 | 1 | 0 | 0 | 0 | 1 | 0 | 0 | 0 | 0 | 0 | 1 | 0 | 0 | 0 |
|   | 0 | 1 | 0 | 0 | 0 | 0 | 0 | 1 | 0 | | | | | | | | | |
| E | 0 | 0 | 0 | 0 | 0 | 0 | 0 | 1 | 0 | 0 | 0 | 0 | 0 | 0 | 1 | 0 | 0 | 0 |
|   | 0 | 0 | 0 | 1 | 0 | 0 | 0 | 1 | 0 | | | | | | | | | |

## FIG. 18

| Dn+1 | Tn+1 | | | | | | | | | DC CONTROL CODE | | | | | | | | |
|------|---|---|---|---|---|---|---|---|---|---|---|---|---|---|---|---|---|---|
| 6 | 0 | 0 | 0 | 0 | 0 | 0 | 0 | 0 | 0 | 0 | 1 | 0 | 0 | 0 | 1 | 0 | 0 | 0 |
|   |   |   |   |   |   |   |   |   |   | 0 | 0 | 0 | 0 | 0 | 1 | 0 | 0 | 0 |
| 7 | 0 | 0 | 0 | 0 | 0 | 0 | 1 | 0 | 0 | 0 | 1 | 0 | 0 | 0 | 1 | 0 | 0 | 0 |
|   |   |   |   |   |   |   |   |   |   | 0 | 0 | 0 | 0 | 0 | 1 | 0 | 0 | 0 |

*FIG. 19*

*FIG. 20*